# EUROPÄISCHE PATENTANMELDUNG

(11) **EP 1 104 940 A1**
(43) Veröffentlichungstag der Anmeldung: **06.06.2001**
(21) Anmeldenummer: 99123924.5
(22) Anmeldetag: 02.12.1999
(51) Int. Cl.: H01L 41/083, H01L 41/04, H01L 41/06

(54) **Festkörperaktor, insbesondere Piezoaktor**

(71) Anmelder: Piezomechanik GmbH, 81673 München (DE)
(72) Erfinder: Pickelmann, L., Dr., 81673 München (DE)
(74) Vertreter: Schwabe - Sandmair - Marx

(57) **Zusammenfassung**

Die Erfindung betrifft einen Festkörperaktor und insbesondere einen piezokeramischen Aktor, der eine Aktormasse hat, die in einer Arbeitsrichtung anregbar ist, um eine Längenausdehnung zu erzeugen, wobei eine Anordnung vorgesehen ist, um ein elektrisches und/oder magnetisches Feld zur Anregung der Aktormasse bereitzustellen, während Verlustwärme über eine Wärmeabfuhreinrichtung abführbar ist, wobei diese Einrichtung erfindungsgemäß aus wenigstens einem Kühlfinger besteht, der sich in Arbeitsrichtung der Aktormasse erstreckt.

## Beschreibung

Die Erfindung betrifft einen Festkörperaktor, der mit einer in wenigstens einer Raumrichtung arbeitenden Aktormasse versehen ist, wobei eine Elektrodenanordnung bzw. Anordnung von Erregungseinrichtungen auf die Aktormasse einwirkt, um eine Bewegung zu initiieren. Bei diesem Festkörperaktor gemäß dem Oberbegriffs des Patentanspruchs 1 ist eine Einrichtung zum Abführen von Wärme vorgesehen.

Festkörperaktoren dienen dazu, bestimmte Bewegungen durchzuführen, beispielsweise um Gegenstände in Schwingungen zu versetzen oder die Schwingungszustände von Gegenständen zu dämpfen. Festkörperaktoren sind hier insbesondere auch als schnelle Stellglieder in einem großen Anwendungsbereich einsetzbar, insbesondere wenn Bewegungen durchzuführen sind, die mit einer hohen Kraft und mittleren bis hohen Frequenzen ausgeführt werden sollen.

Bei den Festkörperaktoren treten hier diverse Probleme auf, die ganz besonders bei Piezoaktoren hervortreten, da diese in der Regel aus Material bestehen, das keine gute Wärmeleitfähigkeit besitzt. Da piezokeramisches Material eine geringe Wärmeleitfähigkeit hat und eine an einen Piezoaktor angelegte gegebenenfalls höherfrequente elektrische Leistung zu einer Verlustleistung führt, erwärmt sich das piezokeramische Material. Aufgrund der minimalen Wärmeleitfähigkeit ergibt sich innerhalb des Kernes eines Piezostapelaktors folglich ein ungünstiges Wärmeprofil und damit ein Wärmestau, der die Leistung des Piezoaktors beinträchtigt. Je größer die Leistung des Piezoaktors sein soll und je großvolumiger der Aktor damit wird, umso problematischer wird der Nachteil des Wärmestaus innerhalb des Piezoaktorstapels. Bei herkömmlichen Piezoaktorstapeln besteht eine mechanische Kopplung der Aktormasse und damit die Möglichkeit der effizienten Wärmeabfuhr nur über die Stirnflächen. Durch diese Geometrie ergibt sich insbesondere bei längeren Aktoren ein Wärmestau in Folge der schlechten Wärmeleitfähigkeit der Keramik. Auch bei höheren Bewegungsfrequenzen, wie sie z.B. auch bei der Schwingungsdämpfung auftreten können, ergeben sich größere Verlustleistungen innerhalb des Aktorstapels und es ist problematisch, die Wärme abzuleiten.

Es ist bekannt, daß piezokeramische Materialien, die bemerkenswerte mechanische Leistungen vollbringen können, bereits bei relativ niedrigen Temperaturen Reichweiteverluste und Leistungsverluste erleiden. So sind bereits Temperaturen von 100° C dazu geeignet, die Leistungsfähigkeit eines Aktors stark zu beeinträchtigen. Temperaturen von 100° C innerhalb eines mittleren Piezoaktorstapels werden jedoch schon bei vergleichsweise geringen Betriebsfrequenzen erreicht und es hat deshalb im Stand der Technik schon diverse Bemühungen gegeben, die in Wärme umgesetzte Verlustleistung eines Piezoaktors zu kompensieren.

Auch ist es bekannt, dass einige besonders effektive Piezokeramiktypen bereits ab Temperaturen von ca. 100 °C ihre Eigenschaften nachteilig verändern. Elektrostriktive Keramiken sind überhaupt nur in einem engen Temperaturbereich (z.B. +/- 10°C um Raumtemperatur) wirksam, so dass jede weitergehende Temperaturdrift nachteilig ist.

So ist ein Lösungsvorschlag bekannt, wonach ein massiver Piezoaktorstapel mit einer Luftgebläsekühlung oder einer Flüssigkeitskühlung versehen wird, um den Wärmestau abzuführen. Da jedoch die piezokeramischen Materialien einen ausgesprochen schlechten Wärmeleitkoeffizienten aufweisen, sind derartige Maßnahmen bereits bei keramischen Piezostapelaktoren mit mittlerer Größe in ihrem Erfolg sehr beschränkt und versagen bei großvolumigen Piezoaktoren. Außerdem ist der technische Aufwand, insbesondere bei der Verwendung einer Flüssigkeitskühlung, aber auch bei der Verwendung einer Luftkühlung ganz enorm und führt letztlich auch dazu, daß der Aktor nicht als geschlossenes System ausgebildet werden kann, sondern an Kühlleitungen oder dergleichen angeschlossen werden muß.

Ein weiterer Versuch, die Problematik des Wärmestaus in den Griff zu bekommen, besteht darin, daß Piezostapelaktoren mit einer in der Regel axialen Mittelbohrung versehen werden, so daß sich hierdurch sog. Ringaktoren ergeben. Auf diese Weise wird es einerseits erreicht, daß die für den Wärmestau zu überbrückende Strecke, um abgeführt zu werden, verringert wird, und andererseits weist der Ringaktorstapel nunmehr eine wesentlich vergrößerte Kühlfläche auf, die für eine Flüssigkeits- oder Luftkühlung zugänglich ist.

Nach wie vor bleibt jedoch das entsprechend verringerte Problem des Wärmestaus. Auch muß der Aktor an seiner Außenfläche, die besonders effektiv durch Flüssigkeit gekühlt werden kann, sehr gut isoliert werden. Trotz guter Isolation kommt es zu Überschlägen bereits bei mittleren Betriebsleistungen und Betriebsfrequenzen eines Aktors, die den Aktor zerstören.

Zudem ist es auch hier nicht möglich, den Aktor als geschlossenes System zu betreiben. Der Aktor braucht eine technische Umgebung, die zur Abführung der Wärme dient, d.h. Kühlmittelleitungen, Kühlmittelpumpen oder dergleichen.

Wird versucht, die in den piezokeramischen Aktorstapeln eingebrachten Elektrodenschichten zur Kühlung heranzuziehen, so ist dies nur möglich, wenn das Verhältnis der aktiven Aktormasse zur inaktiven Elektrodenschichtmasse gravierend verschlechtert wird. Es ergeben sich zudem Probleme bei der Isolierung der Elektroden gegenüber den Wärmeabführungsabschnitten, so daß Aktoren dieser Art lediglich für ganz bestimmte Anwendungen einsetzbar sind und in der Praxis vernachlässigbar sind.

Entsprechende Probleme gibt es prinzipiell bei sämtichen Festkörperaktoren, wobei diese jedoch ganz besonders bei elektrisch dynamisch betriebenen piezokeramischen Stapelaktoren zu Tage treten.

Es ist folglich die Aufgabe der vorliegenden Erfindung, die oben aufgezeigten Nachteile insbsondere für keramische Piezoaktoren so weit als möglich auszuräumen. Insbesondere soll ein Festkörperaktor bzw. ein piezokeramischer Aktor vorgeschlagen werden, dessen Kühlung effizient ist, so daß der Aktor mit höheren Leistungen bzw. Frequenzen betrieben werden kann.

Gemäß der Erfindung hat es sich überraschenderweise gezeigt, daß der Einsatz eines Kühlfingers als wärmeabführende Maßnahme zu ganz außergewöhnlichen Leistungssteigerungen selbst bei großen Aktoren und insbesondere piezokeramischen Aktoren bzw. Aktorstapeln führt. Mit einem Kühlfinger lassen sich Leistungssteigerungen von dem 5 bis 10fachen der ansonsten zu erzielenden Leistung erreichen.

Dabei kommen diverse Arten von Kühlfingern in Betracht, die den Aktor durchziehen oder umgeben können. Auch ist es möglich, Aktoranordnungen mit Kühlfingeranordnungen zu verbinden.

Als Kühlfinger kommen Stäbe aus hochwärmeleitfähigen Materialien in Betracht, wie etwa Kupfer, Aluminium, Silber, Saphir oder dergleichen. Auch ist es denkbar, eine Wärmeleitung über ein sog. Heat-pipe erfolgen zu lassen. Bekanntermaßen sind derartige Heat-pipes teilevakuierte Rohre, innerhalb derer aufgrund der großen Reichweite und Beweglichkeit der Gasatome bzw. Gasmoleküle diese besonders für einen Wärmetransport geeignet sind.

Vorteilhafterweise ist zwischen dem in Arbeitsrichtung der Aktormasse erstreckten Finger und der Aktormasse selbst ein möglichst geringer Spalt vorhanden, so daß eine möglichst gute Wärmeübertragung von der Aktormasse auf den Kühlfinger möglich ist.

Allgemein führt ein Piezoaktor eine Dimension- und/oder Kraftänderung durch. Er kann insbesondere bei Ansteuerung auch kontrahieren, d.h., sich nicht nur ausdehnen, sondern Längenänderungen oder auch Dimensionsänderungen durchführen. Auch Durchmesseränderungen sind möglich.

Es gibt auch Aktoren, die nicht als Stapel aufgebaut sind, wie z.B. Piezorohre. Wenn vorliegend der Begriff Aktorstapel verwandt wird, ist damit auch allgemein jede Form von Aktor gemeint, d.h. jede anregbare Struktur (z.B. Tubus). Der wichtigste Fall sind aber die Stapel.

Die Aktormasse kann lediglich eine Ausnehmung bzw. axiale Mittelbohrung aufweisen, in der dann der Kühlfinger steckt. Andererseits ist es auch möglich, eine Aktormasse mit mehreren Ausnehmungen oder Bohrungen auszustatten.

Wie bereits angedeutet, kann ein entsprechender Festkörperaktor auch so ausgebildet sein, daß der Kühlfinger die Aktormasse umgibt, d.h. der Kühlfinger weist eine Ausnehmung bzw. Bohrung auf, wobei die Aktormasse in dieser Ausnehmung bzw. Bohrung steckt.

Um die Wärmeableitung zusätzlich günstig zu beeinflussen, kann zwischen dem Kühlfinger oder den Kühlfingern sowie der Aktormasse bzw. der mehrgliedrigen Anordnung von Aktormassen ein Wärmeübertragungsmedium vorgesehen sein. Dieses Wärmeübertragungsmedium sollte in Ausbreitungsrichtung der Aktormasse wenigstens im wesentlichen kraftschlußfrei sein. Bereits herkömmliche Wärmeleitkleber, Wärmeleitkautschukke, Wärmeleitpasten oder Isolationsöle steigern die Wärmeabfuhr ganz erheblich und speziell für diesen Zweck vorgesehene Materialien können die Leistungsfähigkeit eines entsprechenden Aktors nochmals äußerst positiv beeinflussen. Bestimmte Arten von Kühlfingern, die beispielsweise aus Kupfer hergestellt sind, können noch mit einer Beschichtung mit hoher Wärmeleitung versehen werden, die wenigstens im wesentlichen nicht oxidiert bzw. korrodiert und insbesondere nicht mit dem Wärmeübertragungsmedium reagiert. Bereits dünne Schichten aus Oxid können die Wärmeübertragung ganz erheblich einschränken und zu enormen Leistungsminderungen führen.

Vorteilhafterweise sind der bzw. die Kühlfinger auf einer ebenfalls sehr gut wärmeleitfähigen Basis angeordnet, die ebenfalls aus Kupfer oder einem vergleichbar gut wärmeleitfähigen Material gefertigt werden kann. Die Basis selbst kann für sich nochmals an eine Wärmeableitungsanordnung anschließbar sein, beispielweise eine Vielzahl von Kühlrippen oder dergleichen, die dann die Wärme an die Umwelt ableiten können.

Nachfolgend wird die vorliegende Erfindung unter Bezugnahme auf bevorzugte Ausführungsformen näher erläutert, wobei weitere Merkmale sowie Vorzüge gemäß der Erfindung offenbart werden. Die bevorzugten Ausführungsformen werden im Hinblick auf Darstellungen erörtert, in denen:
- Fig. 1: ein Thermogramm eines Aktors nach dem Stand der Technik bei einer Betriebsfrequenz von 200 Hz und einer Betriebsspannung von 900 V zeigt;
- Fig. 2: eine erste Ausführungsform gemäß der Erfindung in einer Schnittdarstellung zeigt;
- Fig. 3: eine zweite Ausführungsform gemäß der Erfindung in einem axialen Schnitt darstellt; und
- Fig. 4: eine Draufsicht auf eine schematische Darstellung einer weiteren Ausführungsform gemäß der Erfindung wiedergibt.

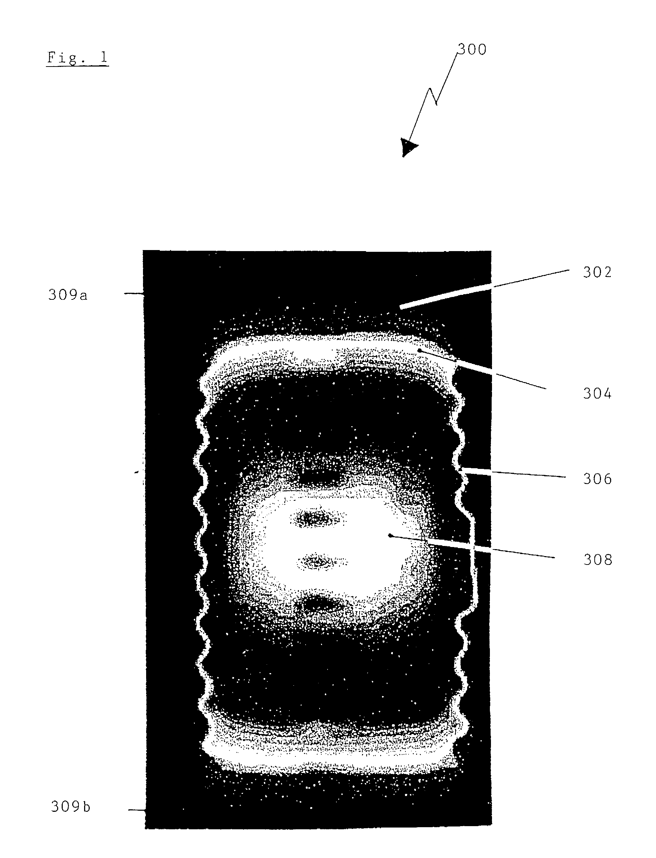

Die Fig. 1 zeigt eine thermografische Aufzeichnung eines piezoelektrischen Stapelaktors 300. Der Aktor ist zylinderförmig und die Zylinderachse erstreckt sich in der größten sichtbaren Ausbreitungsrichtung des Aktors 300. Enden des Aktors 300, die mit dem Bezugszeichen 302 bezeichnet sind, sind schwer zu erkennen, da sie thermisch auf einem niedrigen Niveau sind. Auch die Bereiche 304, 306 des Aktorstapels 300 sind auf einem thermisch niedrigen Niveau, während in dem zentralen Bereich 308 eine hohe Temperatur herrscht. Die Übergangsbereiche zwischen dem hellen Einschlußbereich 304, 306 und dem heißen Kernbereich 308 werden zunehmend heißer.

Die etwa anzunehmenden Endabmessungen des Aktorstapels 300 sind durch die Bezugszeichen 309a, 309b kenntlich gemacht.

Festzuhalten ist, daß, farblich gesehen, die Bereich 302, 304, 306 kühl sind, während der Bereich 308 einen heißen Aktorkern darstellt, was jedoch in der Schwarz-weiß-Darstellung gemäß Fig. 1 nicht erkennbar ist. Der mit dem Bezugszeichen 308 benannte heiße Kern des Aktorstapels 300 ist nicht mehr dazu in der Lage, einen wesentlichen Beitrag zu der Gesamtleistung des Aktors 300 zu erbringen.

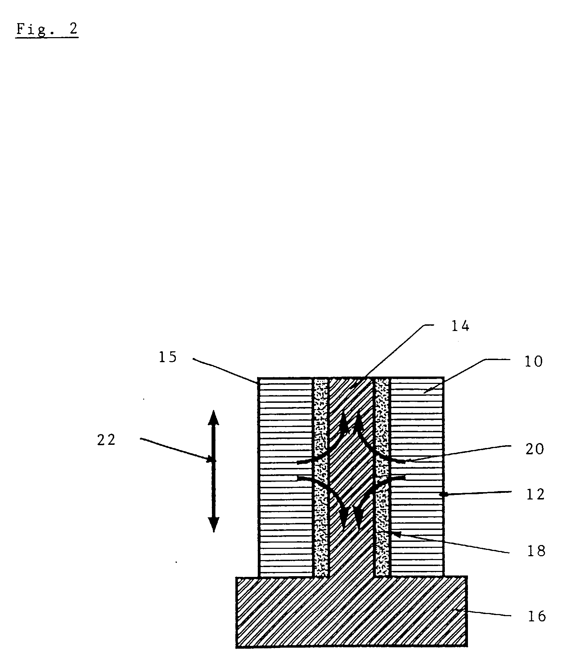

Eine erste Ausführungsform gemäß der Erfindung ist Fig. 2 zu entnehmen. Ein Aktorstapel 10 mit einzelnen Aktorscheiben 12 weist eine Arbeitsrichtung entlang eines Doppelpfeils 23 auf.

Innerhalb einer Öffnung des Aktorstapels 10 ist ein Kühlfinger 14, beispielsweise aus Kupfer, Aluminium, einer speziellen technischen Keramik mit erhöhter Wärmeleitfähigkeit oder dgl. diese teilweise ausfüllend angeordnet. Ein Spalt zwischen dem Kühlfinger 14 und dem Aktorstapel 10 wird mittels eines Wärmeleitmediums, beispielsweise einer Wärmeleitpaste, ausgefüllt.

Der Kühlfinger 14 ruht auf einer Basis 16, mit der der Kühlfinger 14 einstückig ausgebildet, verschraubt oder sonst wie verbunden sein kann. Am günstigsten ist natürlich die einstückige Ausbildung des Kühlfingers 14 mit der Basis 16.

Das Wärmeleitmedium 18 läßt eine Axialbewegung des Aktorstapels 10 in Richtung des Doppelpfeils 23 zu, d.h., ein Kraftschluß über das Wärmeleitmedium 18 zwischen dem Kühlfinger 14 und dem Aktorstapel erfolgt nicht.

Die Basis 16 dient gleichzeitig als Widerlager gegenüber einer Bewegung des Aktorstapels im Verhältnis zu einem Körper oder Gegenstand, der durch den Aktorstapel 10 zu bewegen oder in Schwingungen zu versetzen ist, bzw. dessen Schwingungen zu dämpfen sind.

Die Wärme wird aus dem Aktorstapel 10 abgeführt, wie dies durch die Pfeile 20 verdeutlicht wird. Sobald innerhalb des Kühlfingers 14 ein Wärmegleichgewicht erzielt worden ist, wird sich ein Wärmefluß nur noch zur Basis 16 ergeben. Die in Richtung der Spitze des Kühlfingers 14 gewandten Pfeile werden sich dann ebenfalls zur Basis 16 hin ausrichten, da von der von der Basis 16 abgewandten Spitze des Kühlfingers 14 kaum eine merkliche Wärmeübertragung auf die Umgebung erfolgen wird. Um ein günstigeres Wärmeleitprofil zu erzielen, könnte der Kühlfinger 14 auch konisch bzw. trapezförmig ausgebildet sein, wobei der sich im Querschnitt erweiternde Bereich des Kühlfingers 14 günstigerweise nahe der Basis 16 vorzusehen wäre.

Ein besonderer Vorteil gemäß der Erfindung ist darin zu sehen, daß sich ein Aktor gemäß der Erfindung als geschlossenes System ausbilden läßt, das keine Gas- oder Flüssigkeitsstromzuführungen benötigt, um eine Kühlung vorzunehemen. Die Wärmeabfuhr über den Kühlfinger 14 und die Basis 16 ist vollkommen ausreichend. Natürlich ist es auch möglich, in die Basis 16 noch Kühlleitungen hineinzulegen, wobei trotzdem viele Vorteile für das erfindungsgemäße System sprechen, da keinerlei Kurzschlüsse oder dgl. auftreten können, im Gegensatz zu einer unmittelbaren Kühlung des Aktorstapels mit einer Flüssigkeit oder dgl.

Experimentell gesehen führt der Betrieb eines Piezoringaktors, der einen Außendurchmesser von 15 mm und eine Länge von 36 mm aufweist, bei einer Umgebungstemperatur von ca. 20°C zu einer Oberflächentemperatur in der Mitte des Piezoringaktors von ca. 100°C. Dabei beträgt der Innendurchmesser des Ringaktors, d.h. der Durchmesser der Öffnung im Aktorstapel, ca. 8 mm. Eine Kühlung erfolgt über Konvektion. Die Montage dieses Ringaktors erfolgt in bekannter, herkömmlicher Weise.

Im Gegensatz hierzu erbrachte unter den selben Betriebsbedingungen dieser Ringaktor unter Verwendung eines Kühlfingers aus Kupfer, der 6 mm Durchmesser hatte, eine Temperatur in der Mitte von lediglich 50°C.

Damit ergibt sich eine wesentliche Leistungssteigerung bzw. Steigerung der Betriebsfrequenz, da die Wärme aus dem piezokeramischen Ringaktor, wie er beispielsweise durch den Ringaktor 10 repräsentiert werden kann, gemäß der voriegenden Erfindung wesentlich wirksamer abgeführt werden kann. Insofern daß mechanische Gegenstück, d.h. der Gegenstand auf den eingewirkt werden soll, an die von der Basis 16 abgewandte Spitze des Kühlfingers 14 anstößt, kann auch an das mechanische Gegenstück Wärme übertragen werden, so daß in diesem Fall die Ausrichtung der Pfeile 20 gemäß Fig. 2 auch über einen längeren Betrieb zutreffen kann.

Gemäß Fig. 3 wird ein weiterer Vorzug der Ausführungsform mit Merkmalen gemäß der Erfindung vorgestellt, bei der ein Aktorstapel 100 mit mehreren Bohrungen versehen ist, durch die jeweilige Kühlfinger 142 einer Kühlfingeranordnung 140 hindurchgehen. Dabei sind einzelne piezokeramische Scheiben 120 wiederum zu einem piezokeramischen Stapel verbunden. Zwischen den einzelnen piezokeramischen Scheiben 120 erstrecken sich senkrecht zur Axialrichtung bzw. zur Arbeitsrichtung des Aktors 100 Elektroden, an die entsprechende Spannungen angelegt werden, um das piezokeramische Material zu einer Längenausdehnung anzuregen. Auch hier sind die einzelnen Kühlfinger 142, die sich im zusammengebauten Zustand des Aktors gemäß Fig. 3 in die Bohrungen 140a erstrecken, auf eine Basis 160 festgelegt, bzw. können wiederum einstückig mit dieser ausgebildet sein. Auch ein Verlöten, insbesondere mit Silber- oder Kupferlot oder dgl. des beispielsweise aus Kupfer oder Aluminium gefertigten Kühlfingers 142 mit der Basis 160 ergibt eine gute Wärmeabfuhr. In Arbeitsrichtung, die wiederum durch einen Pfeil mit einem Bezugszeichen 122 angedeutet ist, schließt ein mechanisches Gegenstück an, das gegenüber der Basis 160 ausgelenkt werden soll.

Durch die mehrfache Durchsetzung des Aktorstapels 100 mit Kühlfingern 120 sind die Strecken, die von der Wärme innerhalb des keramischen Materials des Aktors zu überwinden sind, verkleinert, so daß eine effizientere Wärmeableitung erfolgen kann.

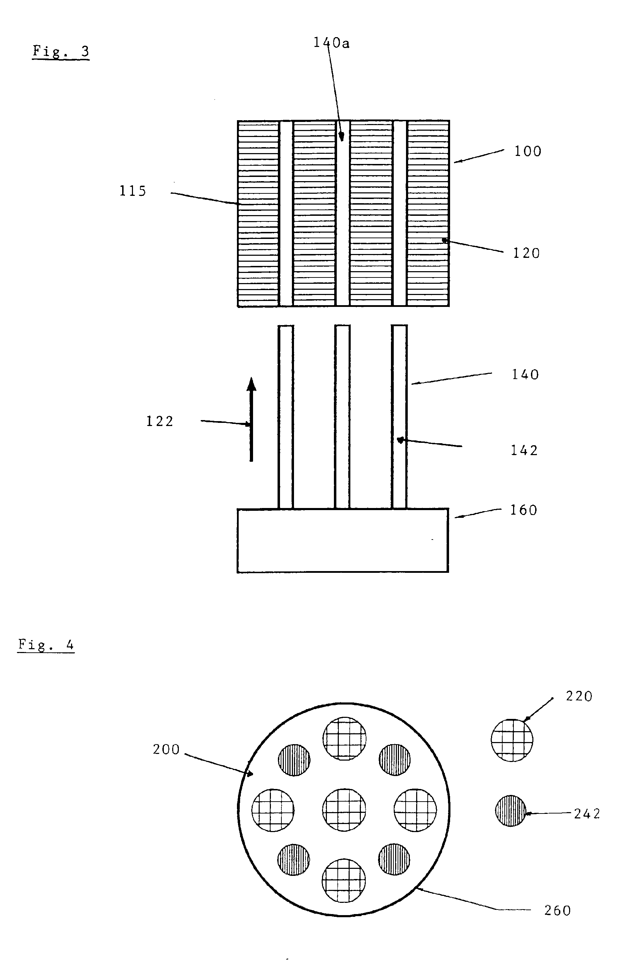

Gemäß Fig. 4 wird eine mehrgliedrige Anordnung mit Merkmalen gemäß der Erfindung vorgeschlagen, wobei auf einer Basis 260 Kühlfinger 242 und jeweilige Aktoren bzw. Aktorstapel 220 zu einem Aktor 200 zusammengefügt sind. Festzuhalten ist, daß die Darstellung rein schematisch ist und die Abstände zwischen den Kühlfingern und den Aktoren relativ groß dargestellt ist, während in der Praxis die Abstände kleiner wären, wobei die Kühlfinger so ausgebildet wären, daß sie die einzelnen Aktoren 220 wenigstens teilweise umgeben würden. Die Basis 260 entspricht dabei im wesentlichen auch den äußeren Abmessungen, die ein korrespondierendes Gehäuse der mehrgliedrigen Aktoranordnungen 200 aufweisen würde.

## Patentansprüche

1. Festkörperaktor mit den folgenden Merkmalen:
a) einem in wenigstens einer Raumrichtung erstreckbaren Abschnitt, der eine Aktormasse (10, 100, 220) zur Verfügung stellt,
b) einer ein elektrisches und/oder magnetisches Feld zur Verfügung stellenden Anordnung (15, 115), wobei das Feld auf die Aktormasse einwirkt;
c) mit einer Einrichtung zum Abführen von Wärme, dadurch gekennzeichnet, daß
d) die Einrichtung zum Abführen von Wärme wenigstens einen Kühlfinger (14, 142, 242) aufweist, der sich in Arbeitsrichtung (22, 122) der Aktormasse erstreckt, wobei bevorzugt ein möglichst geringer Spalt zwischen dem bzw. den Kühlfingern (14, 142, 242) und der Aktormasse vorgesehen ist.

2. Festkörperaktor nach Anspruch 1, dadurch gekennzeichnet, daß die Aktormasse wenigstens eine Ausnehmung (140a), Bohrung oder dgl. aufweist, in die sich der bzw. die Kühlfinger erstrecken.

3. Festkörperaktor nach einem der Ansprüche 1 oder 2, dadurch gekennzeichnet, daß die Aktormasse mehrerer separate Teile (220) umfaßt, zwischen denen sich der wenigstens eine Kühlfinger (242) erstreckt bzw. zugegen ist.

4. Festkörperaktor nach Anspruch 1, dadurch gekennzeichnet, daß der bzw. die Kühlfinger wenigstens einer Ausnehmung bzw. Bohrung oder dgl. hat bzw. haben, wobei die Aktormasse in diese erstreckt ist.

5. Festkörperaktor nach wenigstens einem der Ansprüche 1 bis 4, dadurch gekennzeichnet, daß sich zwischen dem Kühlfinger (14) und der Aktormasse (10) ein Wärmeübertragungsmedium (18) befindet, das bevorzugt in Arbeitsrichtung (22) der Aktormasse wenigstens im wesentlichen kraftschlußfrei ist.

6. Festkörperaktor nach einem der Ansprüche 1 bis 5, dadurch gekennzeichnet, daß der Kühlfinger (14, 141, 242) mit einer Beschichtung mit hoher Wärmeleitfähigkeit versehen ist, die wenigstens im wesentlichen nicht oxidiert bzw. korrodiert oder dgl.

7. Festkörperaktor nach einem der Ansprüche 1 bis 6, dadurch gekennzeichnet, daß die Aktormasse piezoelektrisch ist und einen Aktorstapel (10, 100) mit zugeordneten Elektroden (15, 115) umfaßt.

8. Festkörperaktor nach einem der Ansprüche 1 bis 6, dadurch gekennzeichnet, daß die Aktormasse elektrostriktiv ist.

9. Festkörperaktor nach einem der Ansprüche 1 bis 6, dadurch gekennzeichnet, daß die Aktormasse magnetrostriktiv ist.

10. Festkörperaktor nach einem der Ansprüche 1 bis 9, dadurch gekennzeichnet, daß der bzw. die Kühlfinger (14, 142, 242) auf bzw. an einer Basis (16, 160, 260) festgelegt ist bzw. sind.
